# EUROPEAN PATENT SPECIFICATION

(11) **EP 0 424 390 B1**
(45) Date of publication and mention of the grant of the patent: **29.12.1993**
(21) Application number: 89904035.6
(22) Date of filing: 01.04.1989
(51) Int. Cl.: G01R 19/00, H03K 5/24, H03K 17/693

(54) **VOLTAGE COMPARATOR**
SPANNUNGSKOMPARATOR
COMPARATEUR DE TENSION

(43) Date of publication of application: 02.05.1991
(73) Proprietor: ALCATEL N.V., NL-1077 XX Amsterdam (NL); BELL TELEPHONE MANUFACTURING COMPANY NAAMLOZE VENNOOTSCHAP, B-2018 Antwerpen (BE)
(72) Inventor: WILLOCX, Eddie, Louis, Marie, B-2660 Willebroek (BE)
(74) Representative: Vermeersch, Robert
(86) International application number: EP8900343
(87) International publication number: WO9012324

(56) References cited:
- EP-A- 0 086 397
- US-A- 3 502 905
- US-A- 4 511 810
- IBM Technical Disclosure Bulletin, vol. 13, no. 10, March 1971, (New York, US), R.A. Schulz: "Analog signal selector circuits", pages 2941-2943
- Ferranti Semiconductors Application Note: Power Mosfet ANVI, 1984, pages 1-7

## Description

The present invention relates to a voltage comparator including a current source feeding two parallel branches each of which includes the main path of a first transistor in series with a comparator resistance, with one input terminal of the comparator coupled to the control terminal of one first transistor and the other input terminal coupled to the control terminal of the other first transistor, one or the other first transistor becoming conductive depending on the relative magnitudes of the voltages at the two input terminals.

A voltage comparator of this type is generally known in the art and is for instance described in the European patent application published under n^{o} EP-A-0086397 and disclosing a differential current distributing circuit with the output currents being the collector currents of the two transistors which are bipolar and whose bases constitute the input terminals.

An object of the invention is to use the voltage drop across the comparator resistances in such a way as to improve the operation of the comparator.

This object is achieved due to the fact that each comparator resistance is in series with a diode connected second transistor forming a current mirror with a third transistor whose main path is connected to the corresponding input terminal, the third transistors being made conductive as a result of the potential developed across the associated serial combination of a comparator resistance with the diode connected second transistor.

In this manner, not only can the current amplification produced by the mirror circuits be used advantageously to render the third transistors conductive but one can ensure a design for the comparator, for instance when part of an integrated circuit, which is not affected by production tolerances. This is due to the diode connected transistor part of the current mirror constituting an adaptive load in series with the associated resistance. When current flows through the diode connected transistor, this produces a gate-to-source voltage which can correspond to the gate-to-source voltage of the third transistor when the same integrated circuit technology is used for all such transistors. Thus, with the additional voltage drop across the resistance when the serially connected transistor with its interconnected gate and drain is conductive, this will ensure that the gate-to-source voltage of the third transistor exceeds the threshold for conduction.

One embodiment of the present comparator includes a regenerative feedback circuit between the two comparator resistances in the two parallel branches and constituted by a pair of regeneratively coupled fourth transistors, one with its main path across the other comparator resistance and the other with its main path across the one comparator resistance, the control terminals of these regeneratively coupled fourth transistors being respectively connected to the control terminal of the third transistor in the other branch.

In this way, a faster transition time can be achieved for the voltage comparator when the relative magnitudes of the input voltages are inversed.

It is to be noted that in the above European application EP-A-0086397 on a differential current distributing circuit, the two branches are also coupled by two additional bipolar transistors having their collectors and bases cross coupled in regenerative fashion. Such transistors have however their main paths in series and not in parallel with the resistances in the two branches.

In some applications it is desirable to use a comparator in an integrated circuit which is able to work with relatively high voltages. For this purpose, PMOS transistors with a drain extension allowing a voltage difference of up to 120 volts between drain and source are available but the maximum voltage between gate and source must not exceed 15 Volts.

A second object of the invention is therefore to realize a comparator in which one can control the voltage between the gate and the source of such transistors to avoid excessive amplitudes.

Advantageously, the control terminals of the first transistors are biassed by a second current source identical to the first and a decoupling diode is used in each coupling between an input terminal and the corresponding terminal of the first transistor.

In this manner, with identical current sources for driving the sources of the two first transistors as well as, through the individual biassing resistances, the two gates of these first transistors, one ensures that the maximum gate-to-source voltage for these transistors is that produced by the constant current for the gates flowing through the biassing resistance and this can be designed to remain below the maximum acceptable value for the transistor.

It is to be noted that in the British patent application 2135846, one already has a circuit using two current sources, one for feeding the commoned emitters of two transistors in separate branches and one coupled to the bases of such bipolar transistors through individual resistances. However, no indication is given regarding the relative characteristics of the two current sources and the circuit of the British patent is not a comparator reacting to the relative amplitudes of two input voltages but it is a current splitter distributing two output currents in accordance with the relative magnitudes of the two resistances and this independently of the load impedances.

The same British patent also includes a current mirror coupled to the collectors of the above two fed by the two current sources. But this single current mirror linking the two parallel branches cannot therefore be compares to with the two current mirrors now proposed for a voltage comparator, with one in each of the two parallel branches.

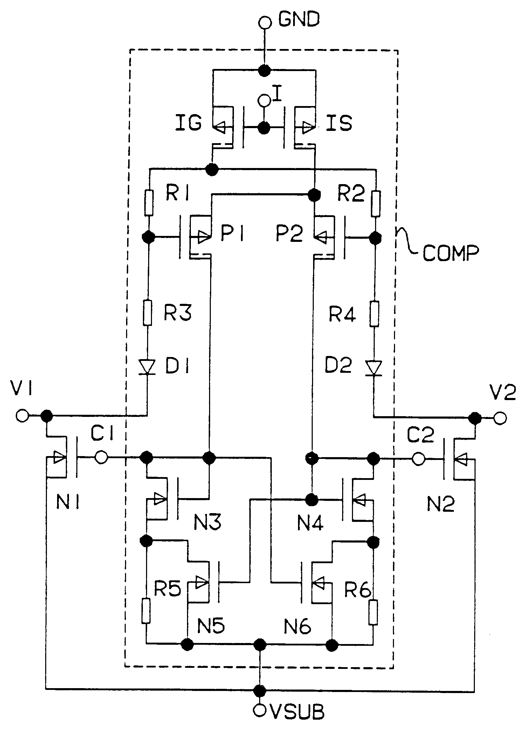

The above mentioned and other objects and features of the invention will become more apparent and the invention itself will be best understood by referring to the following description of an embodiment taken in conjunction with the accompanying drawing which represents the voltage selector and the comparator of the invention.

The circuit shown uses a BCD (Bipolar Cmos Dmos) technology and essentially consists in the two DMOS selector transistors N1 and N2 operated so that their sources are both connected to the substrate, i.e. terminal VSUB, while their drains are connected to the input terminals V1 and V2 respectively.

The rest of the circuit shown constitutes the comparator COMP, as indicated by the interrupted lines, being fed between ground terminal GND and substrate terminal VSUB as well as from the input terminals V1 and V2, and COMP supplying output control signals at terminals C1 and C2 connected to the gates of transistors N1 and N2.

While the actual values of the input DC potentials applied at terminals V1 and V2 are application dependent, each may for instance independently vary within a range of the order of -20 to -60 volts. The switching transistors N1 and N2 are used in order to always maintain the potential at VSUB very close to the lowest negative value present either at terminal V1 or V2.

The description of the circuit can be simplified by noting that it is entirely symmetrical so that apart from the current source IS feeding the source-to-drain paths of the transistors P1 and P2 in the two parallel branches and from current source IG feeding the gates of these two transistors through biassing resistances R1 and R2 in the two parallel branches, all the other elements of COMP are paired, just as this is true for the transistor switches N1 and N2, odd reference numbers being used for the elements on the lefthand side and one being added to each such number for the corresponding even numbered element on the righthand side.

Thus, apart from the current sources IG and IS constituted by identical PMOS transistors with a drain extension operated with their commoned sources connected to ground terminal GND and their commoned gates fed from reference current terminal I, another pair of identical transistors P1/2 of the same type as IG and IS forms an essential part of COMP. The gate of P1/P2 is connected to terminal V1/2 through decoupling diode D1/2 which is in series with resistor R3/4 in order to improve the matching of the two sides of the comparator. Control terminal C1/2 at which the terminal of P1/2 acting as drain and the gate of N1/2 are connected is further coupled to terminal VSUB through diode connected DMOS transistor N3/4 acting as adaptive load in series with resistor R5/6. A further DMOS transistor N5/6 poled as N1/2/3/4 has its drain-to-source path shunted across R5/6 and its gate cross-coupled to control terminal C2/1 in the other branch, N5/N6 providing positive feedback by a regenerative action in order to improve the gain and the speed of the circuit.

Hence, the circuit can work at a relatively high voltage, i.e. up to 100 volts, in view of the nature of the potentials present at terminals V1 and V2 while having a fast response time to transients and with the voltage drop across the switches N1 and N2 being always kept under the value corresponding to a forward biassed diode junction in the associated circuits.

Considering now the operation of the circuit and assuming for instance that the potential at V1 is more negative than at V2, this will lead to output terminal C1 of the comparator being activated in such a way as to saturate transistor switch N1 with the result that the most negative voltage at terminal V1 will appear at output terminal VSUB.

In a switching transition starting with the voltage at V1 only slightly more negative than that at V2, more current will flow from ground at GND and IG through resistor R1 and which is much larger than equalizing resistor R3, than through resistor R2 on the other side, with the result that the gate-to-source voltage of P1 is larger than the corresponding potential for P2, recalling that the floating ends of the two current sources IG and IS are at the same potential when they are identical. This action will entail more current flowing through the main path of P1 than through the corresponding part of P2 and the ensueing higher voltage at C1, developed over R5, as compared to C2 will be amplified due to the cross-couplings involving N5/6. Indeed, more potential will be developed across resistor R5 on the left side so that N6 on the right side will be more conductive than N5 thereby effectively reducing the load impedance at C2 in view of resistance R6 being shunted by transistor N6. Thus, this cumulative effect will rapidly ensure saturation of N1, the full currents from the two sources IG and IS flowing through he left side of the circuit.

With the identical constant current sources SG and SS, one ensures that the maximum voltage between the gate and the source of such a transistor as P1/2 can never exceed the potential across such a biassing resistor as R2, isolated from the input at V2 through decoupling diode D2, and one may resort for P1 and P2, as well as for IG and IS, to the use of PMOS transistors with a drain extension which allow a potential between source and drain of up to 120 volts provided the maximum voltage between gate and source does not exceed 15 volts.

The diode-connected transistor N3/4 constitutes an adaptive load ensuring, when current flows through the transistor, a drain-to-source voltage slightly above the threshold voltage of the transistor. In a given integrated circuit, the threshold voltages of MOS transistors using the same technology are almost equal so that such a diode connected transistor in series with a resistance presents a gate voltage to the transistors N1/2 and N6/5 which is adequately above the threshold voltage, regardless of production tolerances.

Apart from the advantages of the circuit already recited previously, the configuration is also of particular advantage with regard to the parasitic diodes. Indeed, the essential parasitic elements of this type will be constituted by the reverse diodes across the source-to-drain path as well as by the reverse diodes across the source-to-gate junction of N1/2 and in such a way that both types have no detrimental but on the contrary favourable effects. The first mentioned spurious diodes are poled as clamping diodes so that any failure in the circuit will still leave the substrate clamped to the more negative potential present at V1/2 but with a more significant potential difference between VSUB and V1 or V2 than that explained above. The second mentioned spurious diodes also have a beneficial effect since during a switching transition, on a break before make basis, any transient voltage peak at VSUB cannot create an undesirably high potential difference across the gate-to-source junction of N1/2 since the spurious diodes will act as short circuits for this positive transient pulse.

Simulation results for the described circuit have indicated that the gate-to-source voltages of transistors P1/2 can be inversed in about 20 milliseconds for a transition caused by a synthesized line circuit voltage at one of the terminals V1/2 which varies linearly from 0 to -60 volts in 100 milliseconds while the battery potential is maintained at -50 volts at the other terminal V2/1, the load between substrate terminal VSUB and ground terminal GND being 1 milliampere.

## Claims

1. Voltage comparator including a current source (IS) feeding two parallel branches each of which includes the main path of a first transistor (P1/2) in series with, a comparator resistance (R5/6), with one input terminal (V1) of the comparator coupled to the control terminal of one first transistor and the other input terminal (V2) coupled to the control terminal of the other first transistor, one or the other first transistor becoming conductive depending on the relative magnitudes of the voltages at the two input terminals, characterized in that each comparator resistance is in series with a diode connected second transistor (N3/4) forming a current mirror with a third transistor (N1/2) whose main path is connected to the corresponding input terminal, the third transistor (N1/2) being made conductive as a result of the potential developed across the associated serial combination of a comparator resistance with the diode connected second transistor (N3/4).

2. Voltage comparator as claimed in claim 1, characterized in that it includes a regenerative feedback circuit circuit between the two comparator resistances (R5/6) in the two parallel branches and constituted by a pair of regeneratively coupled fourth transistors (N5/6), one with its main path across one comparator resistance and the other with its main path across the other comparator resistance, the control terminals of these regeneratively coupled fourth transistors being respectively connected to the control terminal (C2/C1) of the third transistor in the other branch.

3. Voltage comparator as claimed in claim 1, characterized in that the control terminals of the first transistors (P1/2) are biassed by a second current source (IG) identical to the first (IS) and a decoupling diode (D1/2) is used in each coupling between an input terminal and the corresponding control terminal of the first transistor.

4. Voltage comparator as claimed in claim 3, characterized in that the first transistors (P1/2) biassed by the second current source (IG) are of the PMOS type with a drain extension.

5. Voltage comparator as claimed in claim 4, characterized in that the identical current sources (IS, IG) are constituted by PMOS transistors with a drain extension.

6. Voltage comparator as claimed in claim 2, characterized in that the second (N3/4), third (N1/2) and fourth (N5/6) transistors are of the DMOS type.

7. Voltage comparator according to claim 1, characterized in that the main path of each of said third transistors (N1/2) is connected between a corresponding input terminal (V1/2) and a common output terminal (VSUB) on a substrate.

## Patentansprüche

1. Spannungsvergleicher mit einer Stromquelle (IS), die zwei parallele Zweige speist, von denen jeder den Hauptpfad eines ersten Transistors (P1/2) in Serie mit einem Vergleicher-Widerstand (R5/6) einschließt, bei dem die eine Eingangsklemme (V1) des Vergleichers mit dem Steueranschluß des einen ersten Transistors und die andere Eingangsklemme (V2) mit dem Steueranschluß des anderen ersten Transistors verbunden ist, wobei der eine oder der andere erste Transistor in Abhängigkeit der relativen Größen der Spannungen an den zwei Eingangsklemmen leitend wird,
**dadurch gekennzeichnet,** daß jeder Vergleicher-Widerstand in Serie mit einem mit einer Diode verbundenen zweiten Transistor (N3/4) geschaltet ist und einen Strom-Spiegel mit einem dritten Transistor (N1/2) bildet, dessen Hauptpfad mit der korrespondierenden Eingangsklemme verbunden ist, und daß der dritte Transistor (N1/2) leitend gemacht wird in Abhängigkeit vom Potential, das sich über der entsprechenden Serienkombination ausbildet, die aus einem Vergleicher-Widerstand und dem mit einer Diode verbundenen zweiten Transistor (N1/2) besteht.

2. Spannungsvergleicher nach Anspruch 1,
dadurch gekennzeichnet, daß er mit einer Rückkopplungsschleife versehen ist, die zwischen den zwei Vergleicher-Widerstanden (R5/6) in den zwei parallelen Zweigen eingefügt ist und die von einem Paar von rückkoppelnden vierten Transistoren (N5/6) gebildet wird, mit dem Hauptpfad des einen quer zu dein einen Widerstand und dem Hauptpfad des anderen quer zu dein anderen Widerstand, wobei die Steueranschlüsse dieser rückkoppelnden vierten Transistoren jeweils mit den Steuereingängen (C2/C1) des dritten Transistors in dem anderen Zweig verbunden sind.

3. Spannungsvergleicher nach Anspruch 1, dadurch gekennzeichnet, daß die Steueranschlüsse der ersten Transistoren (P1/2) eine Vorspannung von einer zweiten Stromquelle (IG), die gleich der ersten ist, erhalten und daß eine Entkopplungsdiode (D1/2) in jeder Verbindung zwischen der Eingangsklemme und dein korrespondierenden Steueranschluß des ersten Transistors verwendet wird.

4. Spannungsvergleicher nach Anspruch 3, dadurch gekennzeichnet, daß die ersten Transistoren (P1/2), die von der zweiten Stromquelle (IG) eine Vorspannung erhalten, vom PMOS-Typ sind und eine Drain-Erweiterung besitzen.

5. Spannungsvergleicher nach Anspruch 4, dadurch gekennzeichnet, daß die gleichen Stromquellen (IS, IG) von PMOS-Transistoren mit einer Drain-Erweiterung gebildet werden.

6. Spannungsvergleicher nach Anspruch 2, dadurch gekennzeichnet, daß die zweiten (N3/4), dritten (N1/2) und vierten (N5/6) Transistoren vom DMOS-Typ sind.

7. Spannungsvergleicher nach Anspruch 1, dadurch gekennzeichnet, daß der Hauptpfad eines jeden der dritten Transistoren (N1/2) zwischen einer zugehörigen Eingangsklemme (V1/2) und einer gemeinsamen Ausgangsklemme (VSUB) auf einem Substrat angeordnet ist.

## Revendications

1. Comparateur de tension comprenant une source de courant (IS) alimentant deux branches parallèles, chacune d'entre elles comprenant le trajet principal d'un premier transistor (P1/2) en série avec une résistance de comparateur (R5/6), une borne d'entrée (V1) du comparateur étant couplée à la borne de commande d'un premier transistor et l'autre borne d'entrée (V2) étant couplée à la borne de commande de l'autre premier transistor, l'un ou l'autre des premiers transistors devenant conducteur selon les amplitudes relatives des tensions sur les deux bornes d'entrée, caractérisé en ce que chaque résistance de comparateur est en série avec un deuxième transistor (N3/4) connecté en diode, formant un miroir de courant avec un troisième transistor (N1/2) dont le trajet principal est connecté à la borne d'entrée correspondante, le troisième transistor (N1/2) étant rendu conducteur en raison du potentiel développé aux bornes de la combinaison en série d'une résistance de comparateur et du deuxième transistor (N3/4) connecté en diode.

2. Comparateur de tension conforme à la revendication 1, caractérisé en ce qu'il comprend un circuit de réaction entre les deux résistances de comparateur (R5/6) dans les deux branches parallèles, constitué par une paire de quatrièmes transistors (N5/6) couplés de façon régénérative, l'un ayant son trajet principal aux bornes de l'autre résistance de comparateur, les bornes de commande de ces quatrièmes transistors couplés de façon régénérative étant respectivement connectées à la borne de commande (C1/2) du troisième transistor de l'autre branche.

3. Comparateur de tension conforme à la revendication 1, caractérisé en ce que les bornes de commande des premiers transistors (P1/2) sont polarisées par une deuxième source de courant(IG) identique à la première (IS), une diode de découplage (D1/2) étant utilisée dans chaque couplage entre une borne d'entrée et la borne de commande correspondante du premier transistor.

4. Comparateur de tension conforme à la revendication 3, caractérisé en ce que les premiers transistors (P1/2) polarisés par la deuxième source de courant (IG) sont de type PMOS, avec extension de drain.

5. Comparateur de tension conforme à la revendication 4, caractérisé en ce que les sources de courant identiques (IS, IG) sont constituées par des transistors PMOS, avec extension de drain.

6. Comparateur de tension conforme à la revendication 2, caractérisé en ce que les deuxièmes (N3/4), troisièmes (N1/2) et quatrièmes (N5/6) transistors sont de type DMOS.

7. Comparateur de tension conforme à la revendication 1, caractérisé en ce que le trajet principal de chacun desdits troisièmes transistors (N1/2) est connecté en une borne d'entrée correspondante (V1/2) et une borne de sortie commune (VSUB) d'un substrat.
